Europäisches Patentamt

European Patent Office

Office européen des brevets

(11) Numéro de publication: **0 104 995**
**A1**

(12) # DEMANDE DE BREVET EUROPEEN

(21) Numéro de dépôt: 83401836.8

(22) Date de dépôt: 20.09.83

(51) Int. Cl.³: **H 01 P 5/12**
**H 03 B 5/18**

(30) Priorité: 28.09.82 FR 8216296

(43) Date de publication de la demande:
04.04.84 Bulletin 84/14

(84) Etats contractants désignés:
DE GB IT NL SE

(71) Demandeur: THOMSON-CSF
173, Boulevard Haussmann
F-75379 Paris Cedex 08(FR)

(72) Inventeur: Bert, Alain
THOMSON-CSF SCPI 173, bld. Haussmann
F-75379 Paris Cedex 08(FR)

(72) Inventeur: Mamodaly, Narguise
THOMSON-CSF SCPI 173, bld. Haussmann
F-75379 Paris Cedex 08(FR)

(74) Mandataire: Taboureau, James et al,
THOMSON-CSF SCPI 173, Bld Haussmann
F-75379 Paris Cedex 08(FR)

(54) Combineur compact de dispositifs semiconducteurs fonctionnant dans le domaine des hyperfréquences.

(57) L'invention concerne un combineur de dispositifs semi-conducteurs hyperfréquences, diodes ou transistors, montés selon une topologie qui permet d'en regrouper plusieurs sur une embase prévue pour un seul dispositif.

Les dispositifs semiconducteurs (1) à l'état solide dissipent peu d'énergie, et sont associés à des lignes microbandes (71). Pour augmenter la puissance dissipée en regroupant une pluralité de pastilles semiconductrices sans changer l'embase (10), il est nécessaire de pouvoir replier les lignes microbandes (71) ou les raccourcir. Un substrat (12) très mince (H<$\lambda_o$/40) permet de diminuer la largeur des microbandes (71), pour une même impédance. Un matériau à constante diélectrique très élevée ε > 35, pour le substrat (12) permet de diminuer la longueur des microbandes (71), placées concentriques autour des pastilles.

Applications aux dispositifs émettant plusieurs dizaines de watts hyperfréquences : radars, faisceaux hertziens.

FIG. 4

EP 0 104 995 A1

# COMBINEUR COMPACT DE DISPOSITIFS SEMICONDUCTEURS FONCTIONNANT DANS LE DOMAINE DES HYPERFREQUENCES

La présente invention concerne un combineur compact de dispositifs semiconducteurs, fonctionnant dans le domaine des hyperfréquences. Ce combineur regroupe une pluralité de pastilles semiconductrices sur une même embase, et comporte un circuit d'adaptation d'impédances et d'équilibrages réalisé sur un substrat diélectrique choisi pour diminuer les dimensions des microlignes d'adaptation d'impédance, ce qui permet de compacter le combineur. De plus, le matériau du substrat qui soutient les microbandes peut être choisi tel que le combineur soit très peu sensible aux variations de températures.

L'invention sera exposée sur le cas d'un combineur de diodes, car cela simplifie les explications et les figures, mais son application au cas d'autres dispositifs semiconducteurs tels que les transistors hyperfréquences découle du montage représenté sur les figures, avec des diodes.

L'invention répond à un double problème, propre aux dispositifs hyperfréquences : celui de la puissance et celui des dimensions de montage.

L'obtention de puissances élevées, pouvant atteindre plusieurs watts moyens et plusieurs dizaines de watts crête, nécessaires pour l'émission à longue distance en hyperfréquences, se conçoit actuellement, en ce qui concerne les composants solides, à l'aide de diodes telles que les diodes à avalanche et éventuellement des diodes Gunn. Les puissances requises ne pouvant provenir d'une seule pastille, il est nécessaire d'envisager une combinaison de plusieurs pastilles semiconductrices. Il existe alors plusieurs possibilités :

- association d'une pluralité de diodes en boitier, tel que le combineur de type Kurokawa

- association de plusieurs pastilles à l'intérieur du boitier

- combinaison des deux méthodes précédentes.

Au niveau de la pastille, il n'est pas possible d'accroître de façon très importante la surface de jonction de la diode. Pour conserver le rendement, il faudrait augmenter le courant de polarisation ce qui conduirait à un échauffement de la diode, la température de jonction de la diode étant proportionnelle au produit de la résistance thermique totale par la puissance appliquée, et la résistance thermique ne diminuant pas de moitié lorsque la surface de jonction est doublée. Les courbes de rendement en fonction de la température mettent en évidence un seuil au-delà duquel le rendement diminue. De plus, si l'on augmente la surface de jonction, l'impédance de la diode diminue, ce qui rend plus difficile son adaptation en impédance. Par conséquent, la solution la plus intéressante actuellement pour obtenir de la puissance dans les bandes d'hyperfréquence consiste à associer une pluralité de pastilles élémentaires, et à les faire fonctionner dans leurs conditions optimales.

En ce qui concerne les dimensions du combineur, le problème est lié à l'existence d'embases, disponibles dans le commerce, et répondant à des normes admises par les fabricants de matériel. Un composant nouveau présenté sur une embase interchangeable avec une autre embase existant déjà est plus avantageux pour l'utilisateur que ce même composant présenté sur une embase originale, qui nécessite une modification des conditions d'emploi chez l'utilisateur. En effet, les dispositifs hyperfréquence qui rayonnent de l'énergie sont en général utilisés dans un environnement de matériel qui nécessite que l'embase sur laquelle un nouveau composant est présenté s'adapte à ce matériel préexistant, tels que les guides d'onde ou les pièces de raccordement. C'est l'une des raisons qui ont incité à réaliser le combineur selon l'invention sur une embase initialement prévue pour monter une seule diode, ou une seule pastille semiconductrice. Monter plusieurs pastilles sur une embase est possible, en raison des dimensions très petites des pastilles en hyperfréquence : la difficulté vient de ce qu'une simple mise en parallèle ou en série de plusieurs puces ne permet pas une bonne addition de puissance. Il est nécessaire pour y remédier de réaliser des circuits comportant des lignes microbandes adaptatrices d'impédance, dont la longueur impose normalement une embase de grande dimension.

Mais les caractéristiques des lignes microbandes suspendues relient entre elles leur longueur, leur largeur, l'épaisseur et la constante diélectrique du substrat qui les supporte. C'est en jouant sur l'épaisseur et la constante diélectrique du substrat que l'invention permet d'adapter les dimensions des lignes microbandes en largeur et/ou en longueur, de façon à pouvoir les replier pour les loger sur l'embase du combineur, de façon concentrique aux pastilles semiconductrices.

De façon plus précise, l'invention concerne un combineur compact de dispositifs semiconducteurs fonctionnant dans le domaine des hyperfréquences, comportant, fixés sur une embase métallique, d'une part une pluralité de dispositifs semiconducteurs, d'autre part un substrat diélectrique, en forme de couronne entourant les dispositifs semiconducteurs, et supportant un circuit constitué par au moins deux lignes microbandes et une métallisation circulaire de sortie du combineur, chaque ligne microbande étant réunie par une première extrémité à un dispositif semiconducteur au moyen d'une liaison métallique et par une seconde extrémité à la métallisation de sortie, ce combineur étant caractérisé en ce que l'épaisseur du substrat et la constante diélectrique ε grande du matériau le constituant, sont choisis de façon à diminuer la largeur et la longueur des lignes microbandes (71), qui sont repliées et disposées sur le substrat selon des arcs de cercles concentriques à la métallisation de sortie.

L'invention sera mieux comprise grâce à la description de deux exemples de réalisation, ainsi que deux exemples d'utilisation de combineurs compacts, cette description s'appuyant sur les figures jointes en annexe qui représentent :

    - figure 1 : schéma électrique du montage combineur selon l'art connu

    - figure 2 : schéma en plan d'un combineur selon l'art connu

    - figure 3 : schéma en plan d'un combineur selon l'invention (cas des diodes)

    - figure 4 : vue en plan d'un combineur selon l'invention dans un premier exemple d'application

    - figure 5 : vue en coupe du combineur de la figure précédente

    - figure 6 : vue en plan d'un combineur selon l'invention, dans un second exemple d'applications

    - figure 7 : vue en coupe d'un combineur selon l'invention, monté dans un guide d'onde

    - figure 8 : vue en coupe d'un combineur selon l'invention en montage de Kurokawa

4

- figure 9 : schéma en plan d'un combineur selon l'invention, dans le cas de transistors.

Comme cela a été dit, l'invention sera exposée en s'appuyant sur le cas d'un combineur de diodes, bien que l'invention s'applique de façon plus générale à d'autres semiconducteurs, tels que les transistors par exemple.

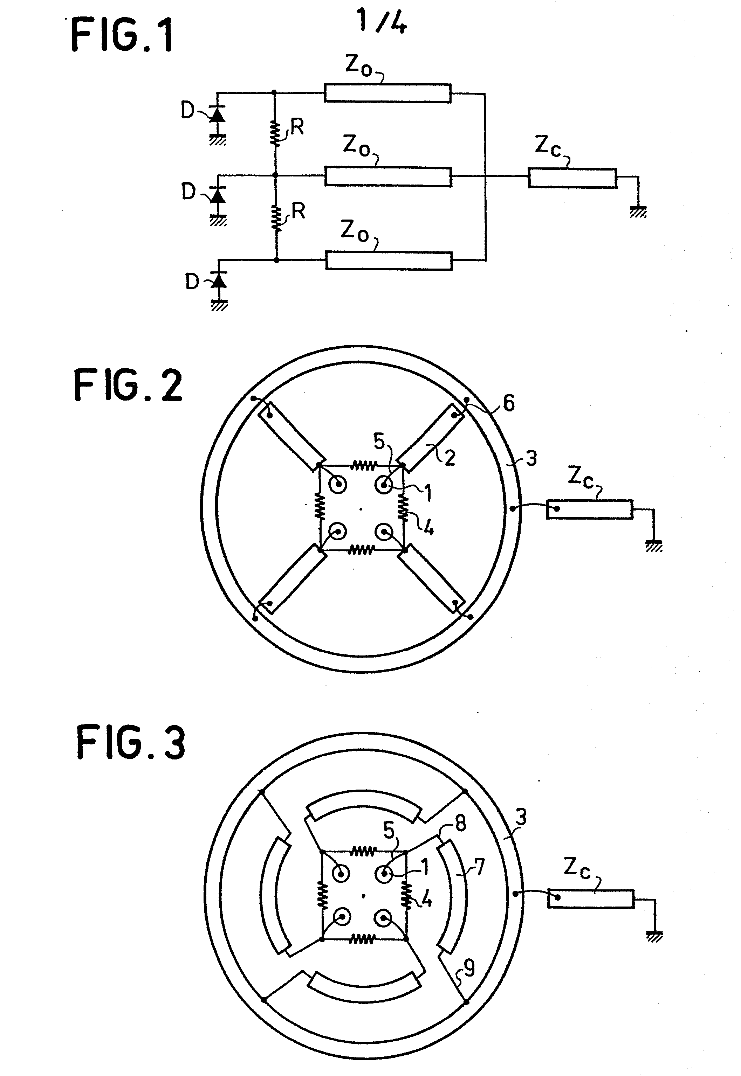

Ainsi, la figure 1 représente le schéma électrique du montage combineur selon l'invention. Ce schéma est connu, et une forme de topologie en a déjà été exposée dans la demande de brevet de la Demanderesse N° 79 087 90, du 6 Avril 1979. Selon ce schéma électrique, la puissance requise est obtenue au moyen de la mise en parallèle d'une pluralité de diodes D, qui débitent sur une charge utile ZC, à travers une ligne microbande d'impédance Z0 qui constitue une adaptation d'impédance, à raison d'une ligne microbande Z0 pour chaque diode D. Des résistances d'équilibrage R, montées entre les diodes, ou les impédances Z0, permettent d'équilibrer le montage. Pour un mode de propagation symétrique, ce montage se comporte de la même façon qu'un montage qui comporterait "n" diodes D montées en parallèle, toutes leurs anodes réunies entre elles et toutes leurs cathodes réunies entre elles, et qui fournirait son énergie à une charge ZC à travers une unique ligne microbande d'impédance Z0/n. Connaissant l'impédance de charge ZC d'une part, et l'impédance Z de chaque diode d'autre part, ceci permet de déterminer l'impédance caractéristique de la ligne microbande Z0 de longueur $\lambda/4$, $\lambda$ étant la longueur d'onde de l'oscillation du système, de façon à transformer une basse impédance en haute impédance.

Ce schéma électrique peut être réalisé de différentes façons. Une première réalisation en est décrite dans la demande de brevet citée précédemment. Une seconde réalisation est représentée en figure 2.

La figure 2 ne comporte que les parties strictement nécessaires à la compréhension de la description, et elle représente la vue en plan d'un combineur selon l'art connu. Pour simplifier et limiter la figure, le combineur ne comporte que quatre pastilles de diodes. Chaque pastille de diode 1 est réunie à une ligne microbande 2 d'adaptation d'impédance, et l'ensemble des lignes microbandes 2 est réuni à une métallisation 3 qui les court-circuite entre elles. Les résistances d'équilibrage R sont réalisées sous forme de dépôts résistifs 4 qui réunissent entre elles les microbandes 2, à leur extrémité située du côté des pastilles de diodes 1. Des liaisons par fils métalliques ou de préférence par rubans métalliques réunissent en 5 chaque pastille de diode à la ligne microbande 2 qui lui est associée et en 6 la même ligne microbande à la métallisation 3 sur laquelle est recueillie l'énergie de sortie.

Cette vue en coupe, sur laquelle ont été supprimés les substrats et diélectriques nécessaires à sa réalisation, représente une topologie circulaire et on voit que pour associer une pluralité de diodes 1, qui peuvent même être réalisées sur un même cristal semiconducteur de très petites dimensions, il est nécessaire de disposer d'un espace relativement grand en raison de la longueur des lignes microbandes 2. En effet, l'impédance d'une microligne suspendue 2 est en relation avec sa largeur et la constante diélectrique ainsi que l'épaisseur du substrat diélectrique qui la supporte ; de plus les microlignes suspendues se présentent généralement comme des rectangles, ayant une largeur relativement importante mais aussi une assez grande longueur. Ainsi, une telle disposition en étoile, telle que représentée en figure 2 n'est pas avantageuse du point de vue de la surface occupée par le combineur, surface trop importante pour qu'un tel combineur soit monté sur une embase prévue pour une seule diode.

La figure 3 représente une vue en plan d'un combineur selon l'invention, selon un schéma simplifié qui montre comment le combineur est replié sur lui-même, les lignes microbandes n'étant plus radiales mais concentriques avec le dispositif de l'embase circulaire. De la même façon que sur la figure 2, seuls les éléments nécessaires aux explications sont représentés sur la figure 3, et l'embase métallique ainsi que le substrat qui supporte le dispositif ne sont pas représentés sur cette figure 3.

Dans la topologie selon l'invention, on a conservé la partie centrale du dispositif regroupant une pluralité de diodes telles que 1, réunies entre elles par des résistances d'équilibrage 4, et reliées à la microbande correspondant à chaque diode par l'intermédiaire d'une liaison électrique 5. On a conservé également la métallisation extérieure 3 sur laquelle est recueillie l'énergie du combineur. Le fondement de l'invention consiste à replier les microbandes sur elles-mêmes de façon à pouvoir concentrer l'ensemble du combineur sur une surface plus petite. Une ligne microbande 2, radiale, telle qu'elle était représentée en figure 2, est remplacée selon l'invention par une ligne microbande 7, concentrique à l'ensemble du dispositif. Cette ligne microbande 7 est réunie, à l'une de ses extrémités, par une liaison 8 avec la diode correspondante, et, à son autre extrémité, par une liaison 9 avec la métallisation de sortie 3.

Deux moyens permettent de faire en sorte que les lignes microbandes occupent moins de surface sur le substrat, et par conséquent permettent de compacter le combineur.

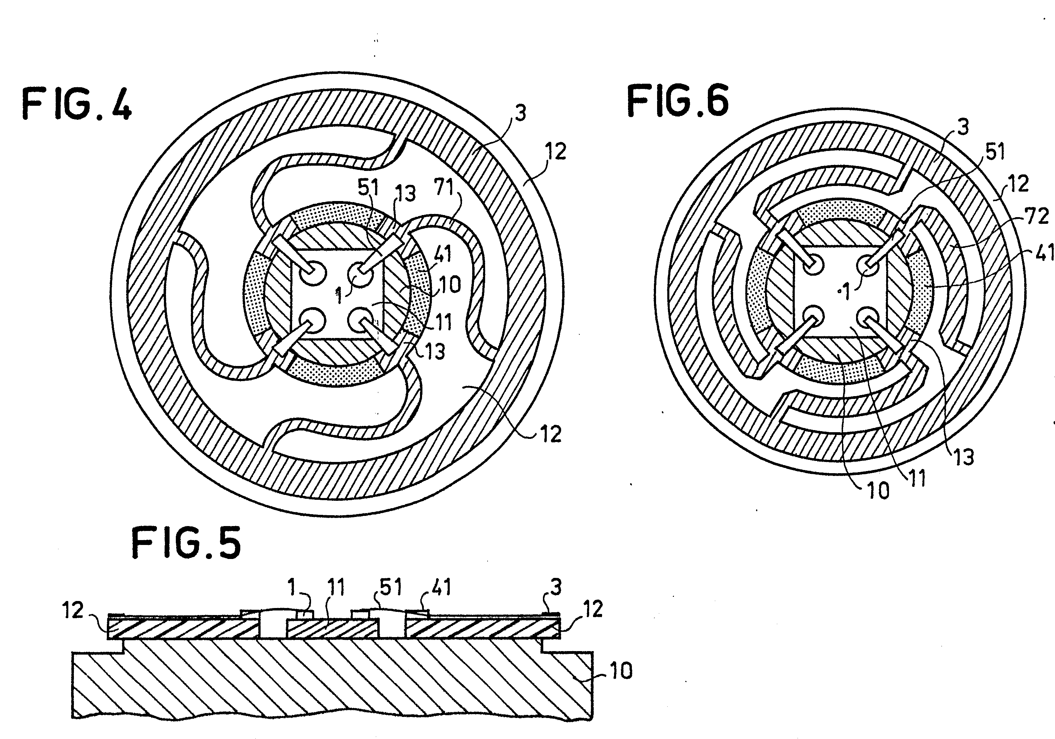

Un premier moyen est représenté en figure 4, qui représente une vue en plan d'un combineur selon l'invention, dans un premier exemple d'application. Comme les précédentes, cette figure est simplifiée au maximum de façon à en rendre la lecture plus aisée, lecture que complète d'ailleurs la vue en coupe de la figure 5.

Le combineur selon l'invention comporte, fixé sur une embase métallique 10 qui sert à la fois à la fixation mécanique du dispositif et à l'élimination des calories :

- d'une part une embase 11 sur laquelle sont fixés la pluralité des dispositifs semiconducteurs tels que 1. Cette embase 11 peut d'ailleurs être un morceau de cristal dans lequel sont réalisés, de façon monolithique, l'ensemble des dispositifs semiconducteurs 1. Cette embase peut être aussi ce que l'homme de l'art appelle un radiateur intégré c'est-à-dire un dépôt métallique, en général de l'or, réalisé sur toute la rondelle de semiconducteur avant obtention par attaque chimique collective des pastilles 1 puis découpe.

- d'autre part, un substrat diélectrique 12, en forme de couronne qui entoure le substrat 11 qui porte les dispositifs semiconducteurs. La périphérie interne du substrat diélectrique 12 comporte une pluralité de métallisations telles que 13, à raison d'une métallisation à l'aplomb de chaque diode 1, et ces métallisations 13 sont réunies deux à deux par un dépôt résistif 41, lequel correspond aux résistances 4 de la figure 3. La périphérie extérieure du substrat diélectrique 12 supporte une métallisation circulaire 3, qui est celle sur laquelle est recueillie l'énergie du combineur. Chaque diode 1 est réunie à la métallisation 13 qui lui correspond par l'intermédiaire d'une liaison 51, de préférence un ruban métallique.

Entre chaque métallisation 13 et un point de la métallisation externe 3 se développent des lignes microbandes 71, dont la géométrie va être expliquée dans ce qui suit.

L'impédance Z0 d'une ligne telle qu'une microbande 71 est essentiellement fonction du rapport W/H, W étant la largeur de la ligne et H étant la hauteur ou l'épaisseur du substrat diélectrique qui supporte cette ligne. Si W est faible par rapport à $\lambda_g/4$, $\lambda_g$ étant la longueur d'onde de propagation d'une ligne microbande déposée sur le substrat, il est possible de replier la ligne sur elle-même. Pour obtenir ce résultat, on utilise un substrat diélectrique 12 de très faibles épaisseurs, typiquement d'épaisseur H de l'ordre de : $H \leqslant$ à $\lambda_g/40$. Pour fixer un ordre de grandeur, avec une alumine de constante diélectrique $\varepsilon$ voisin de 10, et à 20 GHz, $\lambda = 5,76$ mm, la longueur de la ligne $\lambda_g/4 = 1,44$ mm, et l'épaisseur du support diélectrique 12 est inférieur à 0,144 mm.

Ceci permet d'avoir des lignes microbandes qui sont étroites par rapport à leur longueur, et par conséquent, tel que cela est représenté en figure 4, de replier ces lignes microbandes 71 sur elles-mêmes, et les rendre en partie concentriques, plutôt que totalement radiales : il y a donc un effet de diminution des dimensions hors tout du dispositif combineur. Dans le cas où chaque ligne microbande 71 est repliée sur elle-même, une extrémité de la ligne microbande prend naissance directement sur la métallisation 13, tandis que l'autre extrémité de cette ligne aboutit directement sur la métallisation gravée circulaire 3.

Un autre moyen pour compacter un combineur consiste à jouer non plus sur la largeur de la ligne microbande ce qui permet de la replier sur elle-même, mais à jouer sur sa longueur géométrique : c'est ce qui est représenté en figure 6, laquelle représente une vue en plan d'un combineur selon l'invention, dans un deuxième exemple d'application.

Sur cette figure 6, sont représentés une pluralité de dispositifs semiconducteurs 1, supportés par un socle 11 qui peut être également un morceau de cristal monolithique ou bien un radiateur intégré comportant lesdits dispositifs semiconducteurs réalisés simultanément. Ce socle 11 est fixé sur l'embase métallique 10 du combineur et il est entouré par une rondelle d'un substrat diélectrique 12. Sur le bord intérieur de la rondelle 12 de substrat diélectrique sont rapportées, comme dans le cas de la figure 4, des métallisations 13, et des dépôts résistifs 41, chaque dépôt résistif 41 réunissant entre elles deux métallisations 13. De la même façon encore chaque dispositif semiconducteur 1 est réuni à une métallisation 13 par l'intermédiaire d'un ruban métallique 51.

Dans ce qui précède, les pastilles 1 sont soit généralement en silicium ou en arséniure de gallium ; l'ensemble de ces pastilles et du disque diélectrique 12 peut résulter d'une réalisation entièrement monolithique dans laquelle le disque 12 est en silicium ou en As Ga de très haute résistivité.

Cependant, en ce qui concerne les lignes microbandes 72, on peut diminuer leur longueur tout en conservant la même impédance caractéristique, en jouant sur la nature du substrat diélectrique 12 choisi pour avoir une constante diélectrique $\varepsilon$ élevée. Alors que la constante électrique $\varepsilon$ est de l'ordre de 3,8 pour le quartz ou de l'ordre de 10 pour l'alumine, si on choisit un matériau à constante diélectique $\varepsilon$ de l'ordre de 40 la ligne microbande 72 est beaucoup plus courte. Dans ce cas, elle est disposée de façon concentrique par rapport à l'ensemble du dispositif.

Hormis les corps diélectriques à constantes diélectriques $\varepsilon$ élevées, il existe plusieurs compositions à base de titanate dont le coefficient en température est extrèmement faible. Le titanate de baryum $Ba_2Ti_9O_{20}$ a une constante diélectrique comprise entre 35 et 40, mais son usage présente des difficultés liées à la présence d'une phase hygroscopique qui provoque à long terme une dégradation des performances. Le titanate de zirconium $ZrTiO_4$ substitué à l'étain présente lui aussi une constante diélectrique comprise entre 35 et 40 et une tangente de perte de l'ordre de $10^{-4}$ à 5 GHz. L'application de ce matériau à la réalisation de résonateurs diélectriques stables en température a été révélée par la demande de brevet N° 80 04 601, du 29 Février 1981, de la Demanderesse.

La variation de la constante diélectrique en fonction de la température dépend principalement de la nature de la liaison chimique. Pour les matériaux à constantes diélectriques élevées, donc à liaisons ioniques, cette variation provient essentiellement d'un effet de volume ; la dilatation du solide provoque une diminution du nombre de dipôles élémentaires par unité de volume. Dans le cas du titanate de zirconium, le coefficient de dilatation linéaire est faible, et la variation de la constante diélectrique en fonction de la température est encore plus anormalement faible, de l'ordre de - 100 PPM par degré Celsius au lieu de - 200 PPM par degré Celsius. En outre, il est connu que la substitution partielle du zirconium par de l'étain ou du zinc permet d'annuler la variation de la constante diélectrique en fonction de la température.

Outre la substitution d'étain, divers ajouts, en particulier d'oxydes de nickel ou de lanthane, permettent de jouer sur la variation de la constante diélectrique en fonction de la température, ainsi que les techniques de préparation. Enfin l'apport de traces de fer métallique a un effet bénéfique sur les variations des pertes en fonction de la composition.

Ainsi, il est possible avec des matériaux tels que le titanate de zirconium partiellement substitué à l'étain de jouer sur les caractéristiques du matériau en fonction de la température, et de compenser les variations de fréquence d'un oscillateur, dans le temps, lorsque le substrat diélectrique s'échauffe. Par exemple à chaque démarrage de l'oscillateur, une telle composition permet d'éviter la variation de fréquences émises par le combineur, variation qui est connu en anglais par le terme de "Chirp". L'utilisation du titanate de zirconium partiellement substitué à l'étain permet donc non seulement de réaliser des lignes microbandes plus courtes, bien que présentant la même impédance, mais également de stabiliser l'oscillateur en fonction des variations de température.

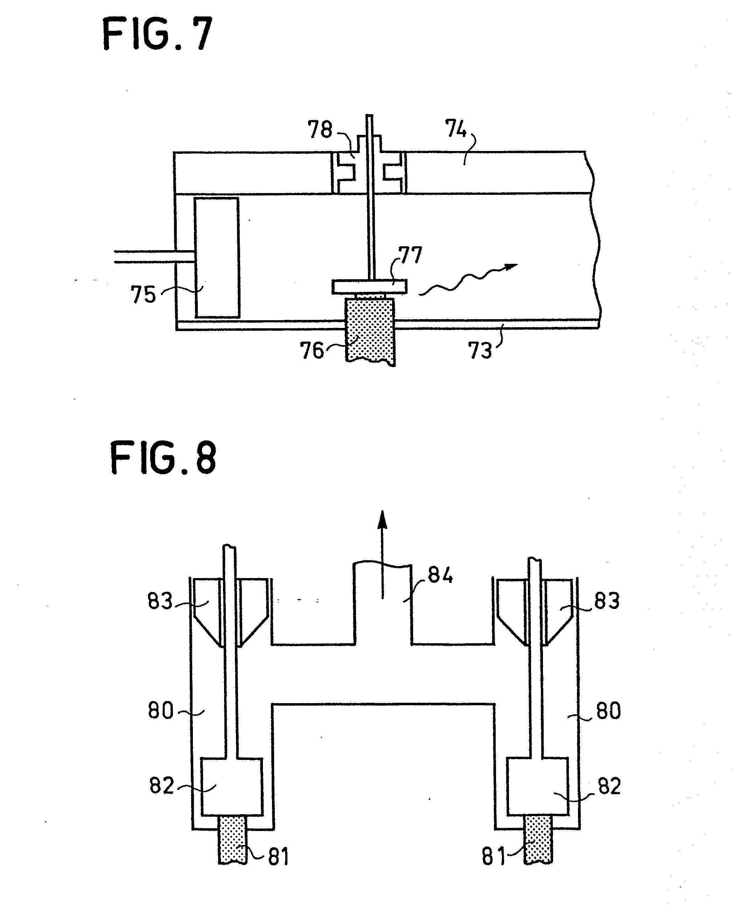

Les figures 7 et 8 montrent deux vues en coupe d'utilisation du combineur selon l'invention, bien que ces deux exemples d'utilisation ne constituent pas une limite à la portée de l'invention.

En figure 7, un combineur selon l'invention est monté dans un guide d'ondes constitué notamment par les cloisons 73 et 74 et par un court-circuit mobile 75 destiné à régler la distance $\lambda_g/4$ du guide d'ondes, entre court-circuit 75 et module multidiode 76. Le combineur est polarisé au moyen d'une plaque rayonnante 77, sur laquelle la polarisation parvient à travers un piège, 78 dit $\lambda/4$. L'avantage du combineur selon l'invention est que pour une même embase 76, la puissance disponible et rayonnée dans le guide d'ondes est plus importante bien que le dispositif mécanique soit identique à celui d'une diode unique montée sur la même embase.

La figure 8 représente un second cas d'impédance de charge sur une pluralité de combineurs selon l'invention, dans un montage de Kurokawa, qui permet d'additionner les puissances de plusieurs modules multidiodes selon l'invention. Dans le montage bien connu de type Kurokawa, chaque combineur selon l'invention 81, est relié à un transformateur d'impédances 82, et à un coaxial dont la tige centrale est couplée magnétiquement à une cavité 80 et traverse un absorbant 83, permettant d'amener la polarisation sur les diodes. L'ensemble des énergies émises par la pluralité des combineurs 81 est recueillie sur la sortie commune 84.

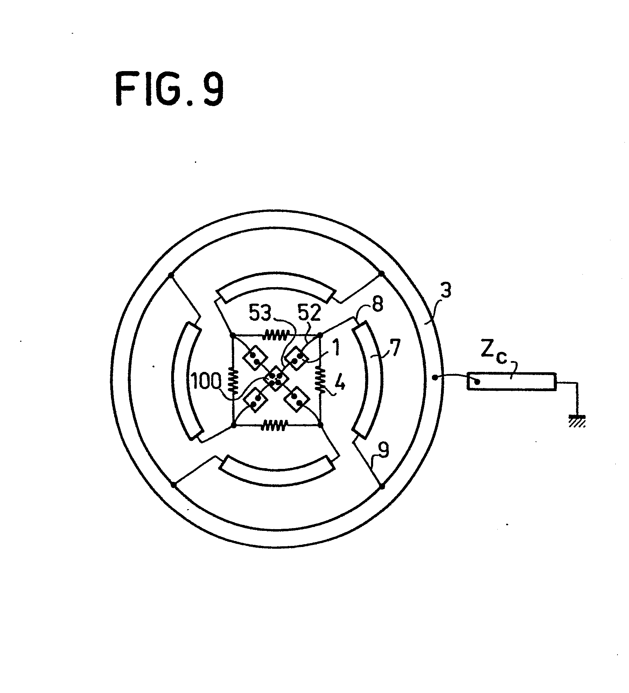

La figure 9 représente un schéma en plan d'un combineur selon l'invention, dans le cas où les pastilles semiconductrices sont des transistors, très généralement des transistors à effet de champ aux hautes fréquences considérées. Cette figure 9 est à rapprocher, pour comparaison, avec la figure 3 qui considérait le cas d'un combineur de diodes.

Si les transistors 1 ont une structure telle que leur drain est constitué par leur substrat, les transistors sont montés en drain commun dès lors qu'une pluralité de transistors sont soudés sur un même socle métallique (non représenté sur cette figure 9). Leurs sources sont reliées par un ruban métallique 52 à une microbande 7, repliée selon l'invention, et leurs grilles sont reliées par un ruban 53 à un condensateur 100 commun à tous les transistors. La valeur de condensateur 100 fixe la fréquence d'oscillation du dispositif, mais l'oscillation n'a lieu que si le combineur présente en sortie une impédance convenable. Le niveau d'impédance à ramener est généralement différent de celui nécessaire pour des diodes, mais l'invention reste applicable, dans son fondement.

Le circuit fonctionne sans qu'il soit nécessaire de polariser les grilles des transistors : il suffit de polariser les sources par une tension négative, appliquée sur la métallisation extérieure 3, et de relier les drains à la masse.

La réalisation d'un combineur de transistors selon la figure 9 peut avoir la configuration de la figure 4 ou celle de la figure 6 : il est facile de remplacer, sur ces figures, les pastilles de diodes par des pastilles de transistors, et d'implanter un condensateur unique au centre des pastilles.

11

Le nombre des semiconducteurs représentés sur les figures, ou leur nature (diode Gunn, à avalanche, transistor à effet de champ monté en drain commun) ne constituent nullement une limitation à la portée de l'invention, qui est précisée par les revendications suivantes.

12

# REVENDICATIONS

1. Combineur compact de dispositifs semiconducteurs fonctionnant dans le domaine des hyperfréquences, comportant, fixés sur une embase métallique (10), d'une part une pluralité de dispositifs semiconducteurs (1), d'autre part un substrat 12, en forme de couronne entourant les dispositifs semiconducteurs, et supportant un circuit constitué par au moins deux lignes microbandes (71) et une métallisation circulaire (3) de sortie du combineur, chaque ligne microbande (71) étant réunie par une première extrémité à un dispositif semiconducteur (1) au moyen d'une liaison métallique (51) et par une seconde extrémité à la métallisation de sortie (3), ce combineur étant caractérisé en ce que l'épaisseur du substrat (12) et la constante diélectrique ε grande du matériau le constituant sont choisis de façon à diminuer la largeur et la longueur des lignes microbandes (71), qui sont repliées, et disposées sur le substrat (12) selon des arcs de cercles sensiblement concentriques à la métallisation de sortie (3).

2. Combineur compact selon la revendication 1, caractérisé en ce que les dispositifs semiconducteurs sont des diodes.

3. Combineur compact selon la revendication 1, caractérisé en ce que, les dispositifs semiconducteurs sont des transistors dont l'électrode non reliée aux lignes microbandes est chargée par une impédance.

4. Combineur compact selon la revendication 1, caractérisé en ce que, en vue de l'intégration monolithique, le substrat (12) est en semiconducteur de très haute résistivité.

5. Combineur compact selon la revendication 1, caractérisé en ce que, $\lambda_g$ étant la longueur d'onde de propagation d'une ligne microbande (71) déposée sur le substrat diélectriques (12), l'épaisseur H du substrat (12) est inférieure à $\lambda_g/40$, et la largeur W d'une microbande (71) faible par rapport à $\lambda_g/4$.

6. Combineur compact selon la revendication 1, caractérisé en ce que la constante diélectrique ε du matériau constituant le substrat diélectrique (12) est supérieure à 35.

7. Combineur compact selon la revendication 6, caractérisé en ce que

13

le substrat diélectrique (12) est constitué de titanate de zirconium partiellement substitué à l'étain, de constante diélectrique $\varepsilon = 36$.

8. Combineur compact selon la revendication 7, caractérisé en ce que, une addition au titanate de zirconium et d'étain de traces d'oxyde de nickel NiO et d'oxyde de lanthane $La_2O_3$ fait varier la constante diélectrique $\varepsilon$ du substrat (12) en fonction de la température de façon à compenser les dérivés en fréquence du combineur en fonction de la température, le rendant plus stable.

# FIG.1

# FIG.2

# FIG.3

FIG.4

FIG.6

FIG.5

2/4

0104995

FIG. 7

FIG. 8

# FIG.9

# 0104995

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| Y | FR-A-2 213 619 (THOMSON-CSF) <br> * Figures 1,5; page 6, lignes 1-9 * | 1,2 | H 01 P 5/12 <br> H 03 B 5/18 |
| | --- | | |
| Y | US-A-3 617 945 (N. ORIME et al.) <br> * Figure 3; abrégé * | 1 | |
| | --- | | |
| A | I. WOLFF:"Einführung in die Mikrostrip-Leitungstechnik", vol. 1, mai 1974, Eigenverlag, Duisburg (DE) <br> "Die Leitungen", pages 29-53 * Figures III.9,III.19,III.20; page 50, ligne 8 - page 51, ligne 16 * | 1,5 | |
| | --- | | |
| A | I. WOLFF:"Einführung in die Mikrostrip-Leitungstechnik", vol. 2, mai 1974, Eigenverlag, Duisburg (DE) <br> "Technologie und Bauelemente", pages 1-11 | 6-8 | **DOMAINES TECHNIQUES RECHERCHES (Int. Cl. 3)** <br><br> H 01 P <br> H 03 F <br> H 03 B |
| | --- | | |
| A | CONFERENCE PROCEEDINGS, 9TH EUROPEAN MICROWAVE CONFERENCE, 17-20 septembre 1979, Brighton (GB), Microwave Exhibitions and Publishers Ltd., Sevenoaks, Kent (GB) <br> Y. ARCHAMBAULT:"The distributed oscillator: A solution for power GaAs IMPATT combining", pages 576-579 * Figure 7 * | 1,2 | |
| | ---      -/- | | |

Le présent rapport de recherche a été établi pour toutes les revendications

| Lieu de la recherche <br> LA HAYE | Date d'achèvement de la recherche <br> 16-12-1983 | Examinateur <br> VAN DER PEET H. |
|---|---|---|

## Office européen des brevets

## RAPPORT DE RECHERCHE EUROPEENNE

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | IEEE TRANSACTIONS ON MICROWAVE THEORY AND TECHNIQUES, vol. MIT-29, no. 7, juillet 1981, New York (US) Z. GALANI et al.:"Single-frequency analysis of radial and planar amplifier combiner circuits", pages 642-654 * Figure 3 * | 1 | |
| A | IEEE TRANSACTIONS ON MICROWAVE THEORY AND TECHNIQUES, vol. MIT-30, no. 2, février 1982, New York (US) D.F. PETERSON:"Radial-symmetric N-Way TEM-line IMPATT diode power combining arrays", pages 163-173 * Figure 15 * | 1,2 | |
| A | DE-A-2 048 528 (N.V. PHILIPS' GLOEILAMPENFABRIEKEN) * Figures 6A,6B; page 7, lignes 7-22 * | 2 | DOMAINES TECHNIQUES RECHERCHES (Int. Cl. ³) |

Le présent rapport de recherche a été établi pour toutes les revendications

| Lieu de la recherche | Date d'achèvement de la recherche | Examinateur |
|---|---|---|
| LA HAYE | 16-12-1983 | VAN DER PEET H. |